Europäisches Patentamt

European Patent Office

Office européen des brevets

(19)

(11) Veröffentlichungsnummer: **0 150 363**
A2

# (12) EUROPÄISCHE PATENTANMELDUNG

(21) Anmeldenummer: 84115064.2

(22) Anmeldetag: 10.12.84

(51) Int. Cl.⁴: **C 04 B 41/00,** C 04 B 41/91, H 01 L 41/22

(30) Priorität: 25.01.84 DE 3402494

(71) Anmelder: **Siemens Aktiengesellschaft, Berlin und München Wittelsbacherplatz 2, D-8000 München 2 (DE)**

(43) Veröffentlichungstag der Anmeldung: **07.08.85 Patentblatt 85/32**

(72) Erfinder: **Januschkowetz, Herbert, Galileistrasse 17, D-8500 Nürnberg (DE)**
Erfinder: **Laub, Hans, Dr., Rankestrasse 3, D-8500 Nürnberg (DE)**

(84) Benannte Vertragsstaaten: **CH DE GB LI NL SE**

(54) **Verfahren zur Metallbeschichtung von piezokeramischen Werkstücken.**

(57)  Die Erfindung bezieht sich auf ein Verfahren zur Metallbeschichtung von piezokeramischen Werkstücken, insbesondere von piezokeramischen Röhrchen, bei denen der piezoelektrische Sinterwerkstoff aus Blei-Zirkonat-Titanat besteht und zur Erzielung eines Piezoeffektes in radialer Richtung das hohlzylindrische Röhrchen innen und außen mit leitfähigen Schichten belegt sein muß. Solche Röhrchen wurden bisher einzeln manuell mit metallischen Schichten versehen. Das sich anbietende stromlose Metallisieren führte bisher zu unbefriedigenden Ergebnissen, da die Metallschichten nicht abreißfest waren und aufgrund der erhöhten Übergangswiderstände zur Erzielung des Piezoeffektes erhöhte Spannungen erforderlich waren. Gemäß der Erfindung wird das Werkstück in einem separaten Verfahrensschritt vor der Metallbeschichtung einer Ultraschalleinwirkung in einer netzmittelhaltigen alkalischen Lösung unterzogen, dem gegebenenfalls eine Ultraschalleinwirkung in ebenfalls netzmittelhaltigem Wasser vorausgeht. Für die alkalische Lösung wird vorzugsweise Alkalicarbonat bzw. -hydroxid und/oder Alkaliphosphat verwendet.

Siemens Aktiengesellschaft
Berlin und München

Unser Zeichen
VPA 84 P 3012 E

Verfahren zur Merallbeschichtung von piezokeramischen Werkstücken

Die Erfindung bezieht sich auf ein Verfahren zur Metallbeschichtung von piezokeramischen Werkstücken, insbesondere von piezokeramischen Röhrchen, bei denen der piezoelektrische Sinterwerkstoff aus Blei-Zirkonat-Titanat besteht und zur Erzielung eines Piezoeffektes in radialer Richtung das hohlzylindrische Röhrchen innen und außen mit leitfähigen Schichten versehen wird.

Beispielsweise für die Verwendung bei Tintenschreibern werden Röhrchen aus Piezokeramik benötigt, die einen radialen Piezoeffekt aufweisen. Dabei soll durch Anlegen einer elektrischen Spannung zwischen Außen- und Innenwand des Röhrchens ein Pumpeffekt realisiert werden. Zu diesem Zweck ist das piezoelektrische Röhrchen außen und innen mit einer Metallschicht zu belegen. Auch andere piezokeramische Werkstücke müssen mit metallischen Elektroden versehen werden.

Die bisher verwendete Methode der Metallbeschichtung, bei der jedes Röhrchen einzeln in Handarbeit mehrmalig außen und innen mit einer Leitsilberpaste bestrichen wurde, die dann eingebrannt werden mußte, war in ihrer Handhabung sehr umständlich, aufwendig und teuer. Da dieser Vorgang für jedes Röhrchen mehrere Male wiederholt werden muß, ließen sich bei dieser Methode große Unterschiede in der Schichtdickenverteilung nicht vermeiden.

Wht 2 Gr / 29.12.1983

0150363

Zur Metallbeschichtung von Keramik sind daneben elektrochemische Verfahren anwendbar, die stromlos ausgeführt werden können. Beispielsweise sind Elektrolyte bekannt, mit denen Nickel- oder Kupfer- und gegebenenfalls Zinn-, Silber- oder Goldschichten auf Werkstückoberflächen aufgebracht werden können, wenn durch vorherige Aktivierung katalytisch wirksame Metallkeime vorhanden sind. In der Praxis hat sich allerdings gezeigt, daß derartig aufgebrachte Metallschichten häufig nicht hinreichend abreißfest sind. Aufgrund hoher Übergangswiderstände sind dann erhöhte Anregungsspannungen für den Piezoeffekt notwendig, was unerwünscht ist.

Aufgabe der Erfindung ist es daher, ein Verfahren zur Metallbeschichtung von piezokeramischen Werkstücken anzugeben, das eine auf Dauer hinreichend haftfeste Metallschicht ermöglicht. Insbesondere für die Beschichtung von Röhrchen geringer Dimensionierung soll dabei gewährleistet sein, daß eine Gleichmäßigkeit der Schichtdicke innen und außen erreicht wird und daß eine größere Zahl von Röhrchen gleichzeitig beschichtet werden kann.

Die Aufgabe wird erfindungsgemäß dadurch gelöst, daß das Werkstück in einem separaten Verfahrensschritt vor der Metallbeschichtung einer Ultraschalleinwirkung in einer netzmittelhaltigen alkalischen Lösung unterzogen wird, dem gegebenenfalls eine Ultraschalleinwirkung in ebenfalls netzmittelhaltigem Wasser vorausgeht. Für die alkalische Lösung wird vorzugsweise ein Alkalicarbonat bzw. -hydroxid und/oder Alkaliphosphat verwendet.

Werkstücke, die aus Blei-Zirkonat-Titanat $[Pb(Zr_xTi_{1-x})O_3]$ bestehen, enthalten von der mechanischen Bearbeitung her an der Oberfläche lose anhaftende, zum Teil sehr kleine Teilchen. Im Rahmen der Erfindung wurde festgestellt, daß diese Teilchen vor einer Metallbeschichtung unbedingt entfernt werden müssen, da ansonsten die aufgebrachten Metallschichten immer eine zu geringe Haftfähigkeit aufweisen. Versuche, diese Teilchen durch Beizbehandlung der Piezokeramik in Säuren zu entfernen, führten nicht zum Erfolg, da in diesem Fall nicht nur die losen Teilchen, sondern auch der Grundwerkstoff selbst von der Säure angegriffen und aufgelockert wird. An einem so beschaffenen Untergrund wäre die Aufbringung einer haftfesten Metallschicht ebenfalls nicht möglich.

Erst durch die Erfindung wird nun überraschenderweise eine hinreichend haftfeste Metallbeschichtung nach der entsprechenden Vorbehandlung in Verbindung mit einer nachfolgenden Aktivierung erreicht. Letztere Aktivierung besteht in bekannter Weise im Aufbringen von katalytisch wirksamen Metallkeimen.

Wenn also mit dem erfindungsgemäßen Verfahren einerseits die Werkstoffoberfläche hydrophil gemacht und andererseits durch die alkalische Lösung gereinigt wird, gelingt durch die Einwirkung von Ultraschall eine vollständige Beseitigung der losen Teilchen ohne Angriff des Grundwerkstoffes. Nach dieser Vorbehandlung kann die Aktivierung, d.h. vorzugsweise ein Tauchen in Zinn-II-Chlorid-, Palladium-II-Chlorid- und Beschleunigerlösung erfolgen und anschließend ohne weiteres ein Beschichten mit einer haftfesten Metallisierung, wobei sich insbesondere eine stromlose Vernickelung oder Verkupferung anbietet. Gegebenenfalls können als Endoberfläche weitere entweder galvanisch erzeugte oder stromlos abgeschiedene Zinn-, Silber- oder Goldschichten aufgebracht werden.

Weitere Einzelheiten und Vorteile der Erfindung ergeben sich anhand nachfolgender Beschreibung von Ausführungsbeispielen in Verbindung mit den Patentansprüchen.

Im einzelnen beziehen sich die Beispiele I und III allgemein auf die Metallbeschichtung von Piezokeramik-Werkstücken, während die Beispiele II und IV die spezielle Ausführung bei piezokeramischen Röhrchen betreffen, wobei aber auch letztere Beispiele auf beliebig geformte Piezokeramikkörper übertragbar sind. Vorteilhaft ist in jedem Fall, daß das erfindungsgemäße Verfahren bei einer Vielzahl von Werkstücken gleichzeitig durchgeführt werden kann, wobei für alle Teile gleichmäßig gute Qualität gewährleistet ist.

Insbesondere bei Piezokeramik-Röhrchen ergeben sich somit gegenüber dem herkömmlichen manuellen Beschichtungsverfahren beachtliche Kosteneinsparungen. Beispielsweise können solche Röhrchen Abmessungen mit der Länge 11 mm, einen äußeren Durchmesser 2,2 mm und der lichten Weite von 1 mm haben, wodurch sie einzeln schwer handhabbar sind. Nach Maßgabe des Gefäßes kann nunmehr eine entsprechende Anzahl von Einzelteilen zusammen behandelt werden.

0150363

Beispiel I

Vernickelung von Piezokeramik-Werkstücken

Ein Werkstück wird einer Behandlung mit folgenden separaten Verfahrensschritten unterzogen:

a) Tauchen in entsalztes Wasser, das 1 cm³/l Netzmittel, beispielsweise Pril, enthält.
Arbeitstemperatur: Raumtemperatur; Zeit: 5 min Im Bad wird das Werkstück gleichzeitig mit Ultraschall beschallt, wobei beispielsweise eine Ultraschallquelle mit 40 kHz und 600 W verwendet wird.

b) Wiederholung des Verfahrensschrittes a) unter Verwendung neuer Lösung.

c) Tauchen in eine Reinigungslösung folgender Zusammensetzung:

Natriumkarbonat-10-hydrat $Na_2CO_3 \cdot 10\ H_2O$   30 g/l
Tri-Natriumphosphat    $Na_3PO_4 \cdot 12\ H_2O$   20 g/l
Pril   1 cm³/l
Arbeitstemperatur: Raumtemperatur; Zeit: 5 min
Einwirkung von Ultraschall wie bei Verfahrensschritt a).

d) Tauchen in Zinn-II-Chloridlösung
Zusammensetzung:

Zinn-II-Chlorid    $SnCl_2$   40 g/l
Salzsäure konz. 37 %ig   HCl   80 cm³/l
Formaldehydlösung 37 %ig   HCHO   25 cm³/l
Arbeitstemperatur: Raumtemperatur; Zeit: 3 min

e) Tauchen in einer Palladium-II-Chloridlösung der
Zusammensetzung:

Palladium-II-Chlorid         $PdCl_2$ ·      0,2 g/l
Salzsäure konz 37 %ig        HCl             5 cm³/l
Arbeitstemperatur: Raumtemperatur
Zeit: 1,5 min

f) Tauchen in einer Beschleunigerlösung der Zusammensetzung:

Natriumhypophosphit    $NaH_2PO_2 \cdot H_2O$   100 g/l
Bernsteinsäure         $C_4H_6O_4$               60 g/l
Ammoniumsulfat         $(NH_4)_2SO_4$            40 g/l

g) Wiederholung des Verfahrensschrittes d)

h) Wiederholung des Verfahrensschrittes e)

Zwischen den Verfahrensschritten a) - h) wird jeweils
gründlich in fließendem Wasser gespült.

i) Umfüllen in ein zweites Gefäß, da das erste durch die
Verfahrensschritte a) und b) aktiviert ist und daher
bei Weiterverwendung ebenfalls vernickelt würde.

j) Wiederholung des Verfahrensschrittes f) mit kürzerer
Tauchzeit:
Arbeitstemperatur: Raumtemperatur; Zeit: 10 s.

k) Ohne zu spülen wird das Werkstück in das Bad zur stromlosen Vernickelung gegeben.

Zusammensetzung des Nickelbades für die stromlose
Vernickelung:

| | | |
|---|---|---|
| Nickelsulfat | $NiSO_4 \cdot 7\ H_2O$ | 35 g/l |
| Bernsteinsäure | $C_4H_6O_4$ | 60 g/l |
| Ammoniumsulfat | $(NH_4)_2 \cdot SO_4$ | 40 g/l |
| 2-Hydroxy-4methylben-zoesäure (2,4 Kresotinsäure) | $C_8H_8O_3$ | 6 g/l |
| Natriumhypophosphit | $NaH_2PO_2 \cdot H_2O$ | 20 g/l |

Betriebswerte des Bades:

| | |
|---|---|
| pH-Wert | 7,5 |
| Badtemperatur | 90 °C |
| Abscheidungsgeschwindigkeit | 15 µm/h |

Zeit: 15 - 20 min

Bei laufendem Betrieb werden dem Bad chargenweise Ergänzungsmengen in Form einer Nickelkomplexsalzlösung und einer Reduktionsmittellösung zugegeben, um die Verluste von Nickel und Reduktionsmittel auszugleichen. Der auf diese Weise erhaltene Nickelüberzug hat eine Schichtdicke zwischen 3 und 5 µm, ist glatt, innen und außen gleichmäßig und weist eine gute Haftfestigkeit auf der Piezokeramik auf.

Beispiel II

Vernickelung von Piezokeramik-Röhrchen mit anschließender Versilberung oder Vergoldung

500 - 1000 Röhrchen mit den oben angegebenen Maßen werden in eine kleine gelochte Versuchstrommel mit Länge 10 cm und Durchmesser ca. 6 cm aus Polypropylen eingefüllt und bei drehender Trommel einem Arbeitsablauf mit den Verfahrensschritt a) bis k) des Beispiels I unterzogen. Es schließen sich folgende Verfahrensschritte an:

l) galvanische Versilberung in einem handelsüblichen Silberbad oder

m) stromlose Vergoldung in einem handelsüblichen Goldbad.

Auf solche Endschichten können in einfacher Weise Kunststoffe aufgebracht werden, was für die Verwendung der Röhrchen bei Tintenschreibern erforderlich ist.

Beispiel III

Verkupferung von Piezokeramik-Werkstücken

Es wird vom Arbeitsablauf des Beispiels I ausgegangen, wobei darauf geachtet wird, daß zwischen den Verfahrensschritten a) - e) jeweils gut in fließendem Wasser gespült wird. Folgende Verfahrensschritte schließen sich an:

n) Umfüllen in ein zweites Gefäß.

o) Stromlose Verkupferung in einem handelsüblichen Kupferbad
   Arbeitstemperatur:        45 ± 2 °C; Zeit: 60 min

Beispiel IV

Verkupferung von Piezokeramik-Röhrchen mit anschließender Verzinnung oder Versilberung

500 - 1000 Röhrchen mit den oben angegebenen Maßen werden in eine gelochte kleine Versuchstrommel aus Polypropylen eingefüllt und bei drehender Trommel folgender Behandlung unterworfen.

Dem Arbeitsablauf mit Verfahrensschritten a) bis e) sowie
   i) bis o) zur Verkupferung wie Beispiel III folgen alternativ:
p) stromlose Verzinnung bei
   Verwendung eines handelsüblichen Verzinnungsbades
oder

q) stromlose Versilberung in einem Bad folgender Zusammensetzung:

Kaliumsilbercyanid                    K Ag(CN)$_2$

handelsübliches Silbertrisalyt 30 %              15 g/l

Natriumcyanid                         NaCN         15 e/l

Arbeitstemperatur: Raumtemperatur; Zeit: 3 min


Durch solche Endschichten wird das Anlaufen des
Kupferüberzuges und eine damit bewirkte Verschlechterung
des Lötverhaltens wirksam verhindert.


14 Patentansprüche

Patentansprüche

1. Verfahren zur Metallbeschichtung von piezokeramischen Werkstücken, insbesondere von piezokeramischen Röhrchen, bei denen der piezoelektrische Werkstoff aus Blei-Zirkonat-Titanat besteht und zur Erzielung eines Piezoeffektes in radialer Richtung das hohlzylindrische Röhrchen innen und außen mit leitfähigen Schichten versehen wird, d a - d u r c h   g e k e n n z e i c h n e t ,  daß das Werkstück in einem separaten Verfahrensschritt vor der Metallbeschichtung einer Ultraschalleinwirkung in einer netzmittelhaltigen alkalischen Lösung unterzogen wird, dem gegebenenfalls eine Ultraschalleinwirkung in ebenfalls netzmittelhaltigem Wasser vorangeht.

2. Verfahren nach Anspruch 1, d a d u r c h   g e - k e n n z e i c h n e t ,  daß die alkalische Lösung eine Alkalicarbonat- bzw. -hydroxid- und/oder eine Alkaliphosphatlösung ist.

3. Verfahren nach einem der Ansprüche 1 oder 2, d a - d u r c h   g e k e n n z e i c h n e t ,  daß die Einwirkung von Ultraschall in der netzmittelhaltigen alkalischen Lösung, vorzugsweise Alkalicarbonat- bzw.-hydroxid- und/oder   -phosphatlösung,etwa 5 Minuten bei Raumtemperatur erfolgt.

4. Verfahren nach Anspruch 1, d a d u r c h   g e - k e n n z e i c h n e t ,  daß die Ultraschalleinwirkung in netzmittelhaltigem Wasser mehrere Male je 5 Minuten mit frischer Lösung erfolgt.

5. Verfahren nach Anspruch 1, d a d u r c h   g e -
k e n n z e i c h n e t , daß die Ultraschalleinwirkung
bei einer Ultraschallfrequenz von etwa 40 kHz
erfolgt.

6. Verfahren nach einem der vorhergehenden Ansprüche ,
d a d u r c h   g e k e n n z e i c h n e t , daß
die Arbeitstemperatur eine gegenüber Raumtemperatur
höhere Temperatur ist.

7. Verfahren nach Anspruch 1, d a d u r c h   g e -
k e n n z e i c h n e t , daß das Werkstück nach der Beschallung einer Oberflächenaktivierung unterzogen
wird.

8. Verfahren nach Anspruch 7, d a d u r c h   g e -
k e n n z e i c h n e t , daß das Werkstück in eine
Zinn-II-Chloridlösung getaucht wird.

9. Verfahren nach Anspruch 7 und 8, d a d u r c h   g e -
k e n n z e i c h n e t , daß das Werkstück anschließend
in eine  Palladium-II-Chloridlösung getaucht wird.

10. Verfahren nach Anspruch 7, d a d u r c h   g e -
k e n n z e i c h n e t , daß das Werkstück in eine
Beschleunigerlösung getaucht wird, welche Natriumhypophosphit, Bernsteinsäure  und Ammoniumsulfat enthält.

11. Verfahren nach einem der vorhergehenden Ansprüche,
d a d u r c h   g e k e n n z e i c h n e t , daß
zwischen einzelnen Verfahrensschritten das Werkstück
unter fließendem Wasser gespült wird.

0150363

12. Verfahren nach einem der vorhergehenden Ansprüche, d a d u r c h   g e k e n n z e i c h n e t , daß einzelne Verfahrensschritte mehrfach durchgeführt werden.

13. Verfahren nach einem der vorhergehenden Ansprüche, d a d u r c h   g e k e n n z e i c h n e t , daß nach der Aktivierung das piezokeramische Werkstück stromlos vernickelt oder verkupfert und gegebenenfalls anschließend verzinnt, versilbert oder vergoldet wird.

14. Verfahren nach einem der vorhergehenden Ansprüche, wobei das Verfahren speziell für eine Innen- und Außenmetallisierung von dünnen piezokeramischen Röhrchen angewendet wird, d a d u r c h   g e k e n n z e i c h n e t , daß das Verfahren bei einer großen Anzahl von Röhrchen gleichzeitig durchgeführt wird, wozu Versuchstrommeln aus Polypropylen oder dergleichen zur Aufnahme einer Vielzahl von Röhrchen vorhanden sind.